# EUROPÄISCHE PATENTSCHRIFT

(11) **EP 0 536 153 B1**
(45) Veröffentlichungstag und Bekanntmachung des Hinweises auf die Patenterteilung: **26.10.1994**
(21) Anmeldenummer: 91909461.5
(22) Anmeldetag: 25.05.1991
(51) Int. Cl.: H05K 5/00

(54) **GEHÄUSE FÜR EINE ELEKTRONISCHE SCHALTUNG**
HOUSING FOR AN ELECTRONIC CIRCUIT
BOITIER POUR UN CIRCUIT ELECTRONIQUE

(30) Priorität: 29.06.1990 DE 9007236 U
(43) Veröffentlichungstag der Anmeldung: 14.04.1993
(73) Patentinhaber: ROBERT BOSCH GMBH, 70442 Stuttgart (DE)
(72) Erfinder: JAKOB, Gert, D-7000 Stuttgart 50 (DE); SCHUPP, Karl, D-7530 Pforzheim (DE); HUSSMANN, Dieter, D-7141 Steinheim (DE); JESSBERGER, Thomas, D-7147 Eberdingen (DE); KARR, Dieter, D-7533 Tiefenbronn (DE)
(86) Internationale Anmeldenummer: DE9100440
(87) Internationale Veröffentlichungsnummer: WO9200660

(56) Entgegenhaltungen:
- EP-A- 373 434
- WO-A-91/05453
- FR-A- 2 328 353

## Beschreibung

### Stand der Technik

Die Erfindung geht aus von einem Gehäuse für eine elektronische Schaltung nach der Gattung des Hauptanspruchs. Ein derartiges Gehäuse ist bekannt aus der DE-PS 25 46 334. In dem Gehäuse ist ein Kühlrahmen untergebracht, der auf einer Leiterplatte befestigt ist und Kammern und einen oberhalb der Leiterplatte befindlichen Boden aufweist, die zur Anbringung sich relativ stark erwärmender Bauelemente dienen. Der Aufbau des Gehäuses, insbesondere der des Kühlrahmens, ist etwas kompliziert, da der Kühlrahmen aus einem Spezialprofil besteht. Daher ist diese Lösung als kostenintensiv anzusehen. Darüber hinaus ist die Wärmeabführung der Leistungsbauelemente verbesserungsbedürftig, da die Wärmeleitwege relativ lang sind.

### Vorteile der Erfindung

Das erfindungsgemäße Gehäuse mit den kennzeichnenden Merkmalen des Hauptanspruchs hat demgegenüber den Vorteil, daß der Kühlrahmen große Flächen zur Anbringung von Leistungsbauelementen aufweist, von denen die Wärmeleitwege zum Druckgußgehäuse sehr kurz sind. Durch den flächigen Kontakt des Kühlrahmens am Gehäuse wird die abzuführende Wärme gut weitergeleitet, so daß Wärmestaus vermieden werden. Dadurch eignet sich das erfindungsgemäße Gehäuse für Schaltungen mit einer großen Anzahl von Leistungsbauelementen mit entsprechend hoher Wärmeleistung. Der Kühlrahmen ist einfach aufgebaut, so daß seine Herstellung keine kostenintensive Fertigungsschritte erfordert.

Die Anordnung der Leistungsbauelemente auf dem Kühlrahmen und die Anbringung des Kühlrahmens auf der Leiterplatte bieten weiterhin den Vorteil, daß die Montage automatisiert werden kann und zum Erstellen der Lötverbindungen nur ein einmaliger Lötvorgang erforderlich ist. Darüber hinaus können sogenannte Leiterplattennutzen verwendet werden, auf denen mehrere Kühlrahmen Platz finden und gleichzeitig über ein Lötbad gefahren werden. Nach dem Verlöten werden aus den Leiterplattennutzen die einzelnen Leiterplatten mit den daran befestigten Kühlrahmen herausgebrochen oder ausgestanzt. Die Herstellung wird damit besonders wirtschaftlich. Durch die erfindungsgemäße Ausbildung des Kühlrahmens und des Gehäuses werden darüber hinaus zusätzliche Dichtstellen vermieden, durch die Staub und Feuchtigkeit ins Gehäuseinnere eindringen könnten.

### Zeichnung

Ein Ausführungsbeispiel der Erfindung ist in der nachfolgenden Beschreibung und Zeichnung wiedergegeben. Letztere zeigt in Figur 1 eine Draufsicht auf den Kühlrahmen mit Schnittansicht des Gehäuses, in Figur 2 einen Querschnitt durch das Gehäuse. Figur 3 zeigt eine Detailansicht eines Befestigungselementes.

### Beschreibung der Erfindung

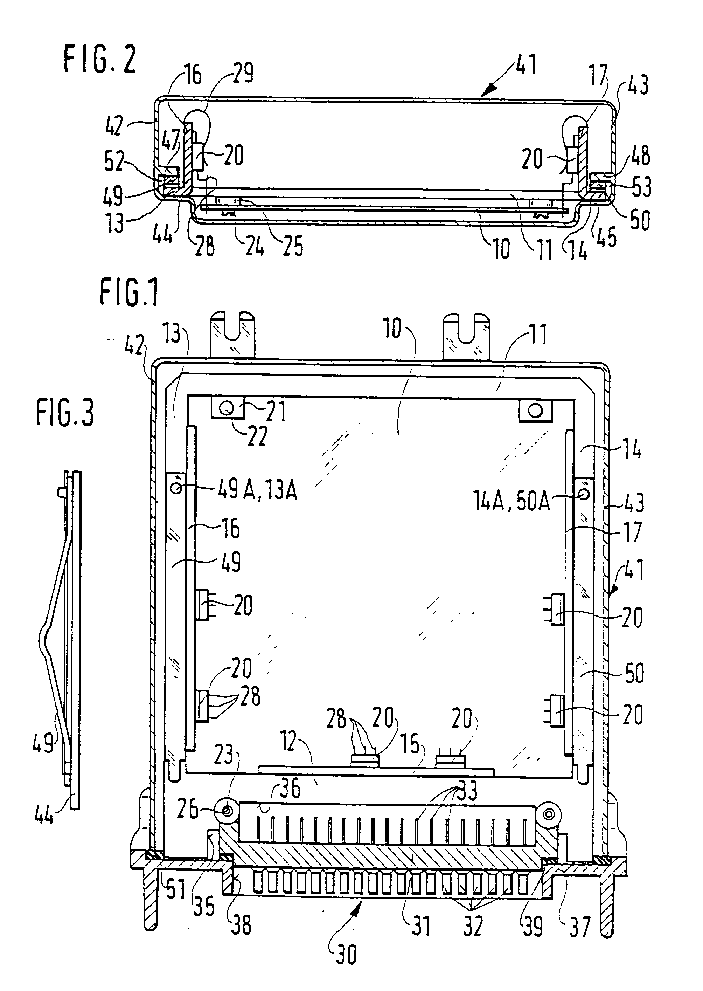

In Figur 1 ist mit 10 eine Leiterplatte bezeichnet, die eine nicht dargestellte elektronische Schaltung trägt. Bei der elektronischen Schaltung handelt es sich insbesondere um eine Steuerelektronik einer Brennkraftmaschine eines Kraftfahrzeuges. Auf der Oberseite der Leiterplatte 10 ist ein geschlossener Kühlrahmen 11 befestigt, der im wesentlichen parallel zur Leiterplattenebene liegt und vorzugsweise aus einem Blechstanzteil besteht. Der Kühlrahmen weist einen rechteckigen Grundriß auf und hat an einer Stirnseite 12 und seinen Längsseiten 13, 14 einen teilweise L-förmigen Querschnitt. Die längeren Schenkel 15 - 17 stehen senkrecht zur Leiterplattenebene und entstehen beispielsweise durch Hochbiegen von dafür ausgebildeten inneren Rahmenabschnitten. Sie dienen als Montagefläche für zu kühlende Leistungsbauelemente 20. Die parallel zur Leiterplattenoberfläche liegenden Schenkel des Kühlrahmens ragen seitlich über die Leiterplatte 10 hinaus.

Zur Befestigung der Leiterplatte 10 am Kühlrahmen 11 dienen ins Rahmeninnere weisende Haltezungen 21 mit Gewindebohrungen 22 an dem der Stirnseite 12 gegenüberliegenden Rahmenabschnitt und Bohrungen 23 in der Stirnseite des Kühlrahmens. Die Befestigung erfolgt mit Schrauben 24, 26, wobei an den Befestigungsstellen zwischen Kühlrahmen 11 und Leiterplatte 10 Distanzscheiben 25 eingelegt sind. Im Gegensatz zur beschriebenen Befestigungsart können die Haltezungen 21 auch rechtwinklig nach unten und im vorgesehenen Abstand wieder parallel zur Leiterplatte zum Rahmeninneren hin gebogen werden, um auf die Distanzscheiben 25 verzichten zu können. Weiterhin kann die Verbindung zwischen Kühlrahmen und Leiterplatte auch mit federnden Rastmitteln oder Nieten erfolgen.

Die Leistungsbauelemente 20 sind durch Anschlußdrähte 28 mit der Leiterplatte verbunden. Mit ihren der Wärmeableitung dienenden Rückseiten liegen sie flächig an den senkrecht zur Leiterplatte stehenden Kühllaschen 15 - 17 an. Mit Metallfederklemmen 29, die sich an den Rückseiten der Kühllaschen und an den Vorderseiten der Leistungsbauelemente abstützen, werden sie fest an die Kühllaschen gepreßt, um eine gute Wärmeübertragung zu ermöglichen.

Auf der einen Stirnseite 12 des Kühlrahmens 11 ist ein Anschlußstecker 30 mit einem Rahmen 31, Kontakten 32 und Anschlußdrähten 33 so befestigt, daß er durch die Schrauben 26 in den Bohrungen 23 mit dem Kühlrahmen und der Leiterplatte verbunden ist. Die Anschlußdrähte 33 des Steckers 30 sind fest mit der Leiterplatte 10 verbunden. Der Kühlrahmen weist dazu in seiner Stirnseite 12 zwei aneinander anschließende rechteckige Ausschnitte 35, 36 auf, von denen der erste, am Rahmenäußeren befindliche, breiter als der Anschlußstecker 30 ist und sich in der Tiefe so weit erstreckt, daß um die Bohrungen 23 ausreichend Rahmenfläche zum Verschrauben verbleibt. Der sich anschließende Rahmenausschnitt 36 entspricht in seiner Breite etwa der inneren Breite des kranzförmigen Rahmens 31 und erstreckt sich in Richtung Rahmeninneres so weit, daß ausreichend Raum für die Durchführung der Anschlußdrähte 33 zur Leiterplatte 10 entsteht.

An dem Steckergehäuse 30 ist eine Frontplatte 37 mit einer kranzförmigen Öffnung 38 auf geeignete Weise befestigt, so daß die Kontakte 32 in die Öffnung 38 ragen. Durch eine zwischen Steckergehäuse 30 und Frontplatte 37 eingelegte Dichtung 39 wird die Öffnung gegen Eindringen von Staub und Feuchtigkeit geschützt.

Die montierte Baueinheit Leiterplatte, Kühlrahmen, Steckerleiste und Frontplatte ist in ein kastenförmiges, an einer Stirnseite offenes, metallisches Gehäuse 41 eingeschoben. An jeder der Längsseiten 42, 43 des Gehäuses ist eine Schulter 44, 45 ausgebildet, auf der die die Leiterplatte seitlich überragenden Kühlrahmenschenkel 13, 14 aufliegen. Oberhalb derselben weist das Gehäuse 41 an seinen Seitenwänden 42, 43 befindliche schmale, längliche Stege 47, 48 auf, die den Kühlrahmen nicht berühren und zusammen mit den Schultern 44, 45 eine Nut 52, 53 bilden.

Auf den Oberseiten der auf den Schultern des Gehäuses aufliegenden Kühlrahmenschenkeln 13, 14 sind Blattfedern 49, 50 befestigt, beispielsweise vernietet. Sowohl die Blattfedern 49, 50 als auch die Kühlrahmenschenkel 13, 14 weisen dazu an ihren der Gehäuseöffnung abgewandten Seite je eine Bohrung 13A, 14A, 49A, 50A auf. Durch die Blattfedern 49, 50 entsteht beim Einschieben des Kühlrahmens in das Gehäuse zwischen Schulter 44, 45 und Steg 47, 48 eine starke Pressung des Kühlrahmens auf die Gehäuseschultern. Dadurch wird ein guter Wärmeübergang ermöglicht.

Das Gehäuse 41 und die Frontplatte 37 sind durch Schrauben, Nieten oder Klammern miteinander verbunden, wobei eine zwischen Gehäuserand und Frontplatte eingelegte Dichtung 51 das Eindringen von Schmutz und Feuchtigkeit verhindert.

## Patentansprüche

1. Gehäuse (41) für eine elektronische Schaltung, insbesondere für eine Steuergeräteelektronik eines Kraftfahrzeuges, mit einem Kühlrahmen (11), an dem eine die elektronische Schaltung aufweisende Leiterplatte (10) befestigt ist, und der mindestens einen Kühlabschnitt aufweist, mit dem an der Leiterplatte angeschlossene Bauelemente (20) wärmeleitend verbunden sind, dadurch **gekennzeichnet,** daß der Kühlrahmen (11) etwa senkrecht zur Leiterplatte (10) stehende Kühllaschen (15, 16, 17) aufweist, die Leiterplatte (10) seitlich überragt und auf Schultern (44, 45) des gut wärmeleitenden, einteiligen Gehäuses aufliegt, und daß auf den auf den Schultern des Gehäuses aufliegenden, seitlichen Schenkeln (13, 14) des Kühlrahmens Blattfedern (44, 45) befestigt sind und daß das Gehäuse Stege (47, 48) aufweist, die sich an den Seitenwänden oberhalb der Schultern (44, 45) befinden und zusammen mit den Schultern eine schmale, längliche Nut (52, 53) bilden, wobei durch die Blattfedern eine Pressung des Kuhlrahmens zwischen Schultern und Stege entsteht.

2. Gehäuse für eine elektronische Schaltung nach Anspruch 1, dadurch gekennzeichnet, daß die Kühllaschen (14, 15, 16) im Rahmeninneren angeordnet sind.

## Claims

1. Housing (41) for an electronic circuit, in particular for an electronic system for a control device of a motor vehicle, having a cooling frame (11) to which a printed circuit board (10) which has an electronic circuit is attached and which has at least one cooling section to which components (20) which are connected to the printed circuit board are connected in a heat-conductive fashion, characterized in that the cooling frame (11) has cooling strips (15, 16, 17) which are located approximately perpendicularly with respect to the printed circuit board (10), protrudes laterally beyond the printed circuit board (10) and rests on shoulders (44, 45) of the single-component housing which conducts away heat well, and in that leaf springs (44, 45) are attached on the lateral legs (13, 14), resting on the shoulders of the housing, of the cooling frame, and in that the housing has webs (47, 48) which are located on the side walls above the shoulders (44, 45) and form with the shoulders a narrow, elongated groove (52, 53), pressure of the cooling frame between shoulders and webs being produced by means of the leaf springs.

2. Housing for an electronic circuit according to Claim 1, characterized in that the cooling strips (14, 15, 16) are arranged in the interior of the frame.

## Revendications

1. Boîtier (41) pour un circuit électronique, en particulier pour l'électronique d'appareil de commande d'un véhicule, avec un cadre de refroidissement (11), sur lequel est fixée une carte de circuits imprimés (10) comportant le circuit électronique et qui comprend au moins un tronçon de refroidissement, avec lequel sont reliés en conduisant la chaleur des éléments de construction (20) raccordés à la carte de circuits imprimés, caractérisé en ce que le cadre refroidisseur (11) comporte des barres de refroidissement (15, 16, 17) sensiblement perpendiculaires à la carte de circuits imprimés (10), qui dépassent latéralement de la carte de circuits imprimés (10) et s'appuient sur des épaulements (44, 45) du boîtier en une pièce, bon conducteur de la chaleur, et en ce que sont fixés sur les branches latérales (13, 14), reposant sur les épaulements du boîtier du cadre de refroidissement des ressorts à lames (44, 45) et en ce que le boîtier comporte des nervures (47, 48), qui se trouvent sur les parois latérales au-dessus des épaulements (44, 45) et forment de concert avec les épaulements une rainure (52, 53) étroite, oblongue, tandis que par les ressorts à lames se crée un serrage du cadre de refroidissement entre épaulements et nervures.

2. Boîtier pour un circuit électronique selon la revendication 1, caractérisé en ce que les barres de refroidissement (14, 15, 16) sont disposées dans l'intérieur du cadre.
